# EUROPEAN PATENT SPECIFICATION

(11) **EP 3 220 557 B1**
(45) Date of publication and mention of the grant of the patent: **20.11.2019**
(21) Application number: 15858578.6
(22) Date of filing: 04.02.2015
(51) Int. Cl.: H04B 10/079, H03K 21/38, H03K 5/1252, H04B 10/075

(54) **BURR REMOVING METHOD AND APPARATUS FOR OPTICAL SIGNAL LOSS SIGNAL**
ENTGRATUNGSVERFAHREN UND VORRICHTUNG FÜR SIGNAL FÜR OPTISCHEN SIGNALVERLUST
APPAREIL ET PROCÉDÉ D'ÉBAVURAGE POUR UN SIGNAL DE PERTE DE SIGNAL OPTIQUE

(30) Priority: 13.11.2014 CN 201410639704
(43) Date of publication of application: 20.09.2017
(73) Proprietor: ZTE Corporation, Shenzhen, Guangdong 518057 (CN)
(72) Inventor: WANG, Juan, Shenzhen Guangdong 518057 (CN); LI, Xiang, Shenzhen Guangdong 518057 (CN); WANG, Rui, Shenzhen Guangdong 518057 (CN)
(74) Representative: Aipex B.V.
(86) International application number: PCT/CN2015/072257
(87) International publication number: WO 2016/074350

(56) References cited:
- WO-A1-2014/071765
- CN-A- 101 568 237
- CN-A- 101 896 048
- CN-A- 102 955 733
- CN-A- 103 399 254
- JP-A- 2011 211 378
- US-A1- 2002 144 188
- US-A1- 2007 076 005
- US-A1- 2008 116 940

## Description

### TECHNICAL FIELD

The present invention relates to the technical field of communications, in particular to a glitch filtering method and an apparatus for an optical signal loss signal.

### BACKGROUND

A transceiver module, called transceiver for short, hereinafter referred to as transceiver or optical fiber transceiver, is an important device in an optical fiber communication system.

The transceiver has a main function of realizing photoelectric/electro-optical conversion, including functions of optical power control, modulation sending, signal detection, IV conversion and limiting amplification decision regeneration, also has functions of anti-counterfeiting information query, TX-disable and the like, and commonly includes an SFP transceiver (i.e., SMALL FORM PLUGGABLE), an SFP+, a GBIC (i.e., abbreviation of Gigabit Interface Converter, which is an interface device for converting a Gigabit electrical signal into an optical signal), an XFP (i.e., 10 Gigabit Small Form Factor Pluggable, which is a hot-pluggable transceiver independent of a communication protocol) and the like.

The transceiver can generally provide an online signal (an online high level represents offline, and an online low level represents online), an optical signal loss signal (a los high level represents that an optical signal is lost, and a los low level represents that the optical signal is normal), a transmission fault signal (a *txfault* high level represents abnormal transmission, and a *txfault* low level represents normal transmission) and other signals as decision signals for working states of the transceiver. However, the optical signal loss signal and the transmission fault signal *txfault* may be in an unstable state and have lots of glitches and jitter at the moment of plugging the transceiver since mechanical contact brings jitter and a chip of the transceiver has a power-on initialization process.

The optical signal loss signal is generally a sensitive signal for a system device using the transceiver, is usually processed by reporting interruption, and is provided to a central processing unit (CPU) of a device system for processing. Thus, when the optical signal loss signal has glitches and jitter, enormous interruptions may be brought to cause abnormal interruption processing of the device system.

In order to solve glitch interference on the optical signal loss signal, according to a glitch processing practice in a related technology, the glitches of the optical signal loss signal are directly filtered in logic; a delay module is generally added; whether a signal is the glitch is judged after delaying for a number of clock cycles; if the signal is the glitch signal, the signal is filtered without reporting; if the signal is not the glitch, the signal after delay is provided to the system device, but the delay of a number of clock cycles already exists in the optical signal loss signal provided at the moment after logic processing. Moreover, the optical signal loss signal is the sensitive signal, and may participate in the processing of many related processes, so each delay processing may cause other problems.

In view of the problem of time delay in the method for filtering the glitches of the optical signal loss signal of the transceiver in the related technology, an effective solution is not proposed at present. Document JP 2011-211378 A discloses a LOS signal correction device, a LOS signal correction method, a LOS signal generating device, and an optical receiver. Problem to be solved is to provide a controller which can prevent alarm quality deterioration due to chattering. A microcomputer is provided with an edge detection unit which detects an edge in a LOS (Loss of Signal) signal before correction, and an LOS output unit which prepares a first state which outputs a value of the LOS signal before correction as a value of the LOS signal after correction and a second state which outputs a reversed value of the LOS signal before correction in the first state as a value of the LOS signal after correction. The LOS output unit transits from the first state to the second state by making it as a trigger that the edge detection unit detects the edge in the LOS signal before correction, and transits from the second state to the first state at the time when a predetermined time passes after the transition to the second state.

### SUMMARY

Embodiments of the present invention provide a glitch filtering method according to independent claim 1 and an apparatus suitable for an optical signal loss signal according to independent claim 6 to at least solve a problem of time delay in the method for filtering the glitches of the optical signal loss signal of a transceiver in a related technology. Further improvements and embodiments are provided in the dependent claims.

In order to achieve an objective of the present invention, according to one aspect of the present invention, the present invention provides the method for filtering the glitches of the optical signal loss signal. The method includes the following steps: setting an online signal to a high level when detecting that the online signal output by the transceiver is changed from the high level to a low level, and starting a timer; setting the online signal to the high level when detecting that the online signal output by the transceiver is changed from the low level to the high level, and resetting the timer; determining that the optical signal loss signal of the transceiver is invalid when the online signal is set to the high level; and setting the online signal to the low level when time of the timer reaches a preset time length.

Preferably, the step that the optical signal loss signal of the transceiver is invalid when the online signal is set to the high level includes: the optical signal loss signal of the transceiver and the online signal output by the transceiver are subjected to or-logic processing when the online signal output by the transceiver is at the high level for representing offline and the optical signal loss signal of the transceiver is at the high level for representing invalidity.

Preferably, the method further includes: a transmission fault signal output by the transceiver is invalid when the online signal is set to the high level.

Preferably, the step that the transmission fault signal output by the transceiver is invalid when the online signal is set to the high level includes: the transmission fault signal of the transceiver and the online signal output by the transceiver are subjected to or-logic processing when the online signal output by the transceiver is at the high level for representing offline and the transmission fault signal of the transceiver is at the high level for representing invalidity.

Preferably, the step that the online signal output by the transceiver is changed from the high level to the low level includes: the online signal output by the transceiver is changed from the high level to the low level when the transceiver is plugged in.

According to another aspect of the present invention, the present invention further provides an apparatus for filtering the glitches of the optical signal loss signal. The apparatus includes the following modules: a filtering module, configured to set an online signal to a high level when the online signal output by a transceiver is detected to be changed from the high level to a low level, and start a timer, wherein the filtering module is further configured to set the online signal to the high level when the online signal output by the transceiver is detected to be changed from the low level to the high level, and reset the timer and the filtering module is further configured to set the online signal to the low level when time of the timer reaches a preset time length; and a logic module, configured to determine that the optical signal loss signal of the transceiver is invalid when the online signal is set to the high level.

Preferably, the step that the logic module is further configured to perform or-logic processing on the optical signal loss signal of the transceiver output by the transceiver and the online output by the transceiver after being processed by the filtering module when the online signal output by the transceiver is at the high level for representing offline and the optical signal loss signal of the transceiver is at the high level for representing invalidity of an optical signal.

Preferably, the logic module is further configured to set a transmission fault signal output by the transceiver to an invalid high level when the online signal is set to the high level.

Preferably, the step that the transmission fault signal output by the transceiver is invalid when the online signal is set to the high level includes: the transmission fault signal of the transceiver and the online signal output by the transceiver are subjected to or-logic processing when the online signal output by the transceiver is at the high level for representing offline and the transmission fault signal of the transceiver is at the high level for representing invalidity.

Preferably, the step that the online signal output by the transceiver is changed from the high level to the low level includes: the online signal output by the transceiver is changed from the high level to the low level when the transceiver is plugged in.

The present invention adopts a technical solution that the method includes the following steps: setting an online signal to a high level when detecting that the online signal output by a transceiver is changed from the high level to a low level, and starting a timer; setting the online signal to the high level when detecting that the online signal output by the transceiver is changed from the low level to the high level, and resetting the timer; determining that the optical signal loss signal of the transceiver is invalid when the online signal is set to the high level; and setting the online signal to the low level when time of the timer reaches a preset time length. The method provided by the invention does not require additional glitch filtering processing, effectively solves a problem of time delay in the method for filtering the glitches of the optical signal loss signal of the transceiver, and avoids the time delay generated when the glitches of the optical signal loss signal of the transceiver are filtered.

### BRIEF DESCRIPTION OF DRAWINGS

Drawings are intended to provide further understanding of the present invention and form a part of the description, are intended to illustrate the present invention in combination with embodiments of the present invention, and are not constituted as a limitation to the present invention.
Fig. 1 is a flow chart illustrating a glitch filtering method for an optical signal loss signal according to embodiments of the present invention;
Fig. 2 is a schematic diagram illustrating a glitch filtering apparatus for an optical signal loss signal according to embodiments of the present invention;
Fig. 3 is a schematic diagram illustrating a glitch filtering apparatus for an optical signal loss signal according to a preferred embodiment of the present invention;
Fig. 4 is a flow chart illustrating another glitch filtering method for an optical signal loss signal according to a preferred embodiment of the present invention; and
Fig. 5 is a sequence diagram illustrating an optical signal in a glitch filtering method for an optical signal loss signal according to a preferred embodiment of the present invention.

### DETAILED DESCRIPTION

Technical solutions in embodiments of the present invention are clearly and completely described below in combination with the drawings in embodiments of the present invention. Apparently, the described embodiments are merely some embodiments of the present invention, rather than all embodiments. It should be understood that the specific embodiments described herein are merely intended to illustrate the present invention rather than to limit the present invention.

It should be noted that embodiments in the present application and features in embodiments may be combined with each other without conflict. Moreover, although a logic sequence is shown in the flow chart, the shown or described steps can be executed in a sequence different from that described herein in some cases. The present invention is described in detail below with reference to the drawings and in combination with embodiments.

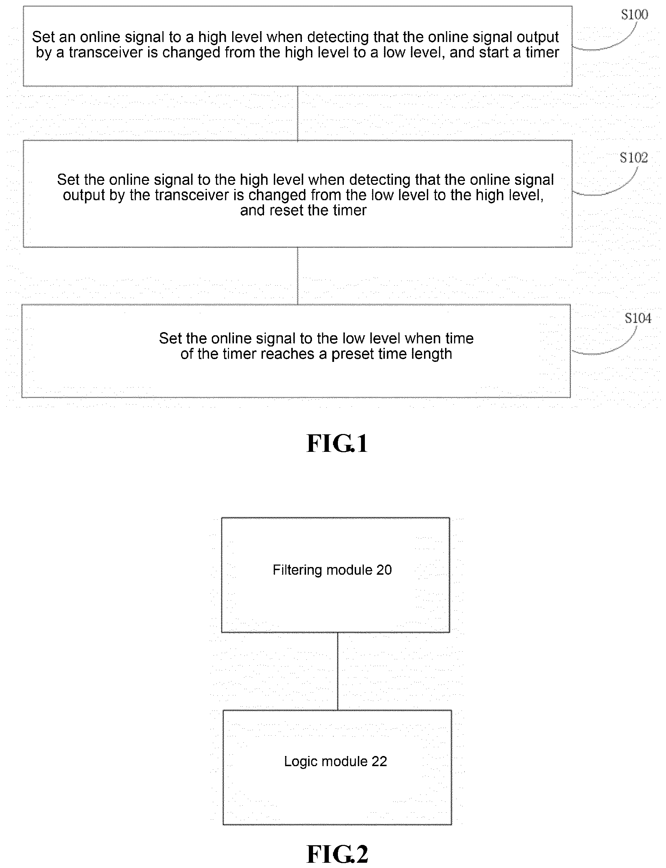

The present embodiment provides a glitch filtering method for an optical signal loss signal. Fig. 1 is a flow chart illustrating a glitch filtering method for an optical signal loss signal according to embodiments of the present invention. As shown in Fig. 1, the method may include the following steps:
Step S100: an online signal is set to a high level when the online signal output by a transceiver is detected to be changed from the high level to a low level; and a timer is started.

The transceiver can generally provide an online signal, an optical signal loss signal, a transmission fault signal *txfault* which are used as decision signals for working states of the transceiver. However, the online signal of the transceiver is changed from the high level to the low level since mechanical contact may bring jitter when the transceiver is plugged or fails. However, due to the presence of lots of glitches, a loss signal reported at this moment is invalid and impractical. The online signal of the transceiver is manually or mechanically and automatically set from the high level to the low level; and the timer is started. The transceiver and a device or a system which uses the transceiver consider that the reported signal is an invalid signal within set time.

Step S102: the online signal is set to the high level when the online signal output by the transceiver is detected to be changed from the low level to the high level; and the timer is reset.

The online signal of the transceiver may be subjected to conversion between the high level and the low level and is in an unstable state when the optical signal of the transceiver has the glitches. When the online signal of the transceiver is changed from the low level for representing online to the high level for representing offline, the glitches of the optical signal are considered to appear; the online signal of the transceiver is set to the high level and is provided to the device or system using the transceiver; and the timer which is timing already is reset.

Step S104: the online signal is set to the low level when the time of the timer reaches the preset time length.

When the transceiver has transceiver signal glitches, the online signal of the transceiver may tend to be stable and does not have the glitches after a period of maintenance or loading. After the preset time length, the online signal of the transceiver is considered to have no glitch and the glitches are unnecessary to be filtered; and a normal online signal can be output to other devices, so the online signal is set to the low level.

In the above method, the optical signal loss signal of the transceiver is invalid when the online signal is set to the high level.

The online signal of the transceiver shows whether the transceiver is online; and when the online signal of the transceiver is set to the high level, embodiments of the present invention indicate that the optical signal loss signal of the transceiver has the glitches, and the signal is invalid to the device or the system using the signal.

In a preferred implementation process, the step that the optical signal loss signal of the transceiver is invalid when the online signal is set to the high level may include: the optical signal loss signal of the transceiver and the online signal output by the transceiver are subjected to or-logic processing when the online signal output by the transceiver is at the high level for representing offline and the optical signal loss signal of the transceiver is at the high level for representing invalidity. For the online signal of the transceiver, the high level 1 represents offline, and the low level 0 represents online. For the optical signal loss signal, the high level 1 represents that an optical signal is lost, and the low level 0 represents that the optical signal is normal. When the online signal of the transceiver is at the high level 1, the optical signal loss signal and the online signal of the transceiver are subjected to the or-logic processing, so that the optical signal loss signal is at the high level 1; and the signal is invalid based on a definition of the loss signal high level.

In the method provided by embodiments of the present invention, the online signal of the transceiver is judged; a time cycle N is set for judging time from the transceiver is plugged in to whether the transceiver is powered on to work normally; the timing is started when the transceiver is plugged in; the transceiver is reported to be still in an offline stage before the time cycle N is reached; meanwhile, the optical signal loss signal is judged to be invalid; and the online signal of the transceiver and the optical signal loss signal of the transceiver are reported normally in real time after the time cycle N is reached. The method effectively solves problems of signal glitches and signal instability caused by mechanical jitter in a transceiver plugging stage without adding additional glitch filtering processing, and effectively filters the glitches of the optical signal loss signal of the transceiver without generating additional time delay.

By reference to the steps shown in Fig. 1, in order to filter the glitches of an optical signal transmission fault signal and avoid generating a problem of time delay, the glitches of the optical signal transmission fault signal are further filtered in a manner of referring to the online signal in one preferred embodiment of the present embodiment, e.g., a transmission fault signal output by the transceiver is determined to be invalid when the online signal is set to the high level.

The online signal of the transceiver shows whether the transceiver is online; and when the online signal of the transceiver is set to the high level, embodiments of the present invention indicate that the transmission fault signal of the transceiver has the glitches, and the signal is invalid to the device or the system using the signal.

In the preferred implementation process, the step that the transmission fault signal of the transceiver is invalid when the online signal is set to the high level may include: the transmission fault signal of the transceiver and the online signal output by the transceiver are subjected to or-logic processing when the online signal output by the transceiver is at the high level for representing offline and the transmission fault signal of the transceiver is at the high level for representing invalidity. For the online signal of the transceiver, the high level 1 represents offline, and the low level 0 represents online. For the transmission fault signal *txfault*, the high level 1 represents abnormal transmission, and the low level 0 represents normal transmission. When the online signal of the transceiver is at the high level 1, the optical signal transmission fault signal *txfault* and the online signal are subjected to the or-logic processing, so that the transmission fault signal is at the high level 1; and the signal is invalid based on the definition of the high level of the transmission fault signal.

In a preferred implementation process, the step that the online signal output by the transceiver is changed from the high level to the low level may include: the online signal output by the transceiver is changed from the high level to the low level when the transceiver is plugged in.

In embodiments of the present invention, the online signal of the transceiver is judged; a time cycle N is set for judging time from the transceiver is plugged in to whether the transceiver is powered on to work normally; the timing is started when the transceiver is plugged in; the transceiver is reported to be still in an offline stage before the time cycle N is reached; meanwhile, the optical signal loss signal and the transmission fault signal are judged to be invalid; and the online signal of the transceiver, the optical signal loss signal and the transmission fault signal of the transceiver are reported normally in real time after the time cycle N is reached. Thus, problems of signal glitches and signal instability caused by mechanical jitter in a transceiver plugging stage are effectively solved without adding additional glitch filtering processing; and the glitches of the optical signal loss signal of the transceiver are effectively filtered without generating additional time delay.

The present embodiment further provides a glitch filtering apparatus for an optical signal loss signal. Fig. 2 is a schematic diagram illustrating a glitch filtering apparatus for an optical signal loss signal according to embodiments of the present invention. As shown in Fig. 2, the apparatus can include the following modules:
a filtering module 20, configured to set an online signal to a high level when the online signal output by a transceiver is detected to be changed from the high level to a low level, and start a timer, further configured to set the online signal to the high level when the online signal output by the transceiver is detected to be changed from the low level to the high level, and reset the timer, and further configured to set the online signal to the low level when time of the timer reaches the preset time length; and
a logic module 22, coupled to the filtering module 20 and configured to determine that the optical signal loss signal of the transceiver is invalid when the online signal is set to the high level.

In a preferred embodiment, the step that the optical signal loss signal of the transceiver is invalid when the online signal is set to the high level can include: the optical signal loss signal of the transceiver and the online signal output by the transceiver are subjected to or-logic processing when the online signal output by the transceiver is at the high level for representing offline and the optical signal loss signal of the transceiver is at the high level for representing invalidity of an optical signal.

In a preferred embodiment, the logic module 22 can also be configured to determine a transmission fault signal output by the transceiver to an invalid high level when the online signal is set to the high level.

In a preferred embodiment, the step that the transmission fault signal output by the transceiver is invalid when the online signal is set to the high level can include: the transmission fault signal of the transceiver and the online signal output by the transceiver are subjected to or-logic processing when the online signal output by the transceiver is at the high level for representing offline and the transmission fault signal of the transceiver is at the high level for representing invalidity.

In a preferred embodiment, the step that the online signal output by the transceiver is changed from the high level to the low level can include: the online signal output by the transceiver is changed from the high level to the low level when the transceiver is plugged in.

Embodiments of the present invention are described below in combination with the preferred embodiments.

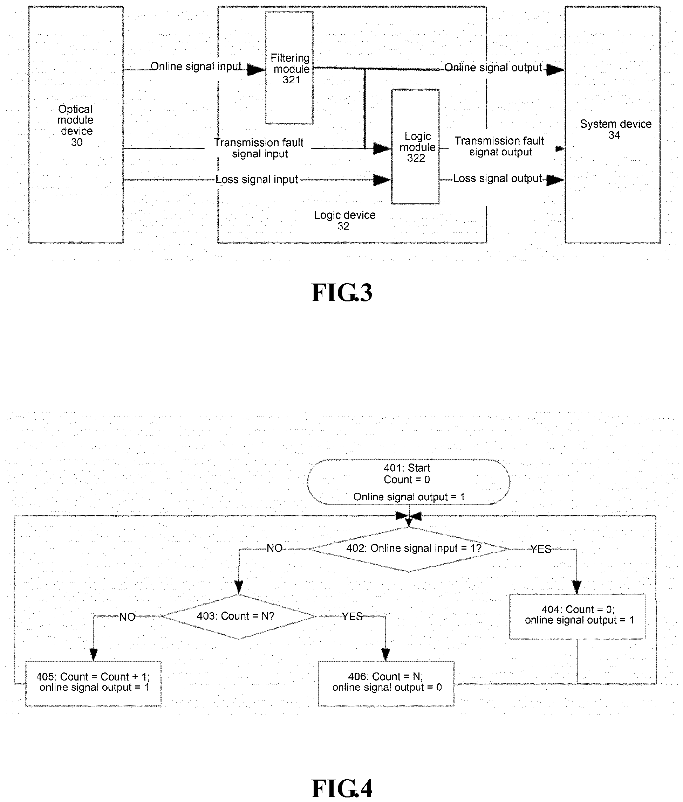

Fig. 3 is a schematic diagram illustrating a glitch filtering apparatus for an optical signal loss signal according to a preferred embodiment of the present invention.

Common transceivers include SFP, SFP+, GBIC, XFP and the like. A transceiver apparatus shown in Fig. 3 can be applied to an existing transceiver. According to Fig. 3, we set the following signal types and names for describing the present embodiment:

System device 34: a device using the transceiver, e.g., a switch, a router and the like.

Logic device 32: a device which is configured to realize the method and the apparatus described in the preferred embodiment of the present invention, can be a programmable logic device such as a CPLD (Complex Programmable Logic Device) or a FPGA (Field-Programmable Gate Array), and can also be a software code, and even a combination of hardware and software.

The logic device 32 may at least include the filtering module 321 in order to realize a logic code of the method and the apparatus described in the preferred embodiment of the present invention, and is primarily used for receiving an online signal of an optical signal of the transceiver (optical module device 30) and setting the output online signal of the transceiver according to the method provided by the preferred embodiment of the present invention. The logic module 322 is configured to process the optical signal loss signal of the transceiver and the transmission fault signal of the transceiver according to the online signal of the transceiver.

An input of an online signal of the transceiver entering the logic device module: a signal which is directly generated by the transceiver and fed into the method and the apparatus described in the preferred embodiment of the present invention.

An input of an optical signal loss signal of the transceiver entering the logic device module: a signal which is directly generated by the transceiver and fed into the method and the apparatus described in the preferred embodiment of the present invention.

A transmission fault signal input *txfault-in* of the transceiver entering the logic device module: a signal which is directly generated by the transceiver and fed into the method and the apparatus described in the preferred embodiment of the present invention.

A transceiver online signal output *online-out* output by the logic device module: a signal processed in the method and the apparatus described by the preferred embodiment of the present invention.

A transceiver optical signal loss signal output *los-out* output by the logic device module: a signal processed in the method and the apparatus described by the preferred embodiment of the present invention.

A transceiver transmission fault signal output *tx-fault* output by the logic device module: a signal processed in the method and the apparatus described by the preferred embodiment of the present invention.

The method is illustrated in combination with the apparatus and may include the following steps:
Step 1, a clock signal *clk* is selected; and a count is configured to judge a clock cycle N of the transceiver from plug-in to power-on for normal working.
Step 2, a transceiver online signal input *online-in* is used as a judgment standard. If the logic detects that the online signal input of the transceiver is at the high level, the count is reset to 0 and a transceiver online signal output *online-out* is set to 1.
Step 3, if the online signal input of the transceiver is detected to be the low level 0, the count starts to count and the online signal output *online-out* of the transceiver is set to 1.
   If the online signal input *online-in* of the transceiver is detected to keep the low level 0 and the count counts to N, the online signal output *online-out* of the transceiver is set to 0. If the high level is found in the online signal input *online-in* of the transceiver during counting, the counting is stopped, and the step 2 is executed.
Step 4, the obtained transceiver online signal output *online-out,* an optical signal loss signal input *los-in* and a transceiver transmission fault signal input *txfault-in* are subjected to or-logic processing, so as to obtain a transceiver optical signal loss signal output *los-out* and a transceiver transmission fault signal output *tx-fault.*
Step 5, the obtained transceiver loss signal output *los-out* and the transceiver transmission fault signal output *txfault-out* are supplied to the system device for use.

Compared with the prior art, according to the preferred embodiment of the present invention, problems of signal glitches and signal instability caused by mechanical jitter and a transceiver chip initialization process in the transceiver plugging stage are effectively solved; meanwhile, the transceiver optical signal loss signal and the transceiver transmission fault signal *txfault* can be reported in real time in a transceiver online stage without resulting in a time delay problem of an ordinary glitch filtering technology.

Fig. 4 is a flow chart illustrating a glitch filtering method for an optical signal loss signal according to a preferred embodiment of the present invention; and Fig. 4 shows a schematic diagram of embodiments of the present invention, and is illustrated in combination with the drawings.

The problems of the glitches and signal instability brought in the transceiver plugging stage are mainly resulted from the mechanical jitter at the time of plugging the transceiver and the signal instability in a transceiver chip power-on initialization stage. In order to solve the problems, a period of transceiver signal invalid time N is set from a first low level when the transceiver is detected online; the online signal of the transceiver, the optical signal loss signal of the transceiver and the transmission fault signal *txfault* of the transceiver are considered as invalid signals within this period of time, i.e., the online signal *online-out* of the transceiver output by the logic module is set to the high level, the optical signal loss signal *los-out* is set to the high level, and the transmission fault signal *txfault-out* of the transceiver is set to the high level. The optical signal loss signal of the transceiver and the transmission fault signal *txfault* of the transceiver are reported normally in a normal online stage of the transceiver.

The transceiver is directly fed into the online signal input *online-in* of the transceiver, the optical signal loss signal input *los-in* of the transceiver and the transmission fault signal input *txfault-in* of the transceiver of the logic device. The logic module obtains the online signal output *online-out* of the transceiver, the optical signal loss signal output of the transceiver and the transmission fault signal output *txfault-out* of the transceiver sent out of the logic module by adding glitch removal and delay processing for the online signal input *online-in* of the transceiver, for use by the system device.

Fig. 4 is a flow chart illustrating the preferred embodiment of the present invention. As shown in Fig. 4:
Step 401: a transceiver online signal *online-out* output by the logic module is set to 1, and the count is set to 0 in a logic start stage.
Step 402: whether the level of the online signal input *online-in* of the transceiver is at the high level, i.e., whether a logic signal is 1, is detected.
Step 403: the online signal input *online-in* of the transceiver is 0, whether the timer expires to the preset time length N is judged.
Step 404: the online signal input *online* of the transceiver is 1 indicates that the transceiver is offline, the online-out is set to 1, and the count is set to 0.
Step 405: when the online signal input *online-in* of the transceiver is detected to be at 0 level, it indicates that the transceiver is plugged in; the counting is started (count = count + 1); and the online signal output *online-out* of the transceiver is set to 1.
Step 406: when the online signal input *online-in* of the transceiver is detected to be at 0 level and the count counts to the preset time length N, it indicates that the transceiver plug-in time exceeds the set time for judging from plug-in of the transceiver to power-on for normal working; the count is configured to stop counting; and meanwhile, the online signal output *online-out* of the transceiver is set to 0.

When the count does not count to N in the counting process, and the online signal input *online-in* of the transceiver is detected to be at 1 level again, it indicates that an interference signal exists, the previous count is invalid, and the step 402 is restarted.

A stable transceiver online signal *online-out* without plugging glitches and abnormal signals is obtained through the above logic processing; the signal, the transceiver optical signal loss signal *los-in* and the transmission fault signal *txfault-in* of the transceiver are subjected to or processing, so that the stable transceiver optical signal loss signal *los-out* and transmission fault signal *txfault-out* of the transceiver without plugging glitches are obtained.

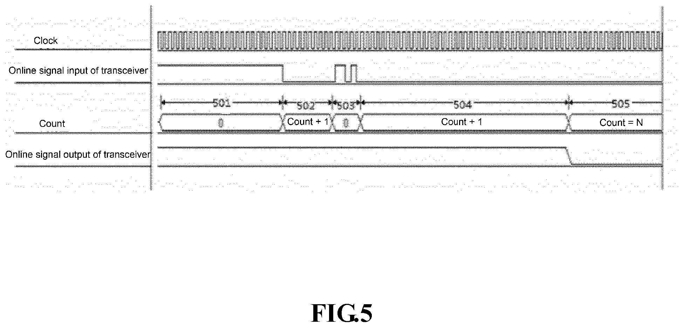

Fig. 5 is a sequence diagram illustrating an optical signal in a glitch filtering method for an optical signal loss signal according to a preferred embodiment of the present invention. It can be seen from Fig. 5 that the clock *clk* is a system clock signal; the online signal input *online-in* of the transceiver is the online signal of the transceiver directly supplied to the logic module by the transceiver; the count is a count signal of the logic module; the online signal output *online-out* of the transceiver is the online signal of the transceiver provided to the system device after processed by the logic module; and N represents the clock cycle set by the logic module for judging time from plug-in of the transceiver to power-on for normal working.
(1) 501 stage indicates that the online signal input *online-in* of the transceiver is at the high level before the transceiver is plugged in; the count of the logic module in the stage is 0; the online signal output *online-out* of the transceiver is at the high level.
(2) 502 stage indicates that the transceiver is plugged in; the online signal input *online-in* of the transceiver is changed to the low level at the moment; the count of the logic module starts to count; and the online signal output *online-out* of the transceiver is at the high level.
(3) 503 stage indicates a stage that the online signal input *online-in* of the transceiver is unstable caused by the mechanical jitter when the transceiver is plugged in; the online signal input *online-in* of the transceiver has the glitches at the moment; the high level and the low level jump; the count of the logic module is re-changed to 0; and the online signal output *online-out* of the transceiver is at the high level.
(4) 504 stage indicates a transceiver plug-in stable stage; the online signal input *online-in* of the transceiver is stably kept at the low level at the moment; but optical signal loss signal output *los-out* of the transceiver and the transmission fault signal output *txfault-out* of the transceiver are in an unstable state due to power-on initialization of the chip of the transceiver at the moment; the count of the logic module starts to count; and the online signal output *online-out* of the transceiver is at the high level.
(5) 505 stage indicates that the count counts to N; the initialization of the transceiver is completed; all signals are in a stable stage; the online signal input *online-in* of the transceiver is stably kept at the low level at the moment; the count keeps a count-N stage; and the online signal output *online-out* of the transceiver is at the low level.

The description will be made below in combination with an example.

A switch device using the SFP transceiver employs the method provided by the preferred embodiment of the present invention. The time taken from plugging the transceiver in the switch device to powering on the transceiver to work normally is estimated according to daily maintenance experience and transceiver design parameters; and the period of time is preset to 500 ms.
(1) At a moment that the transceiver is plugged, the online signal input *online-in* of the transceiver is changed from 1 to 0; and the time is preset to 500 ms according to the method provided by the preferred embodiment of the present invention. During this period, the transceiver signal is considered to have the glitches and needs to be filtered; if the online signal output is set to 1, then the online signal output *online-out* is reported as 1 for representing offline; the loss signal, the transmission fault signal and the online signal are subjected to logic processing, so that the optical signal loss signal output *los-out* is 1 for representing invalidity, and the fault signal output *txfault-out* of the transmission is 1 for representing invalidity.
(2) Counting is started for 500 ms at the same time; if a level change 0->1->0 of the online signal input *online-in* is detected within 500 ms, the signal is considered to have the glitches; the timer is reset; and the online signal output *online-out* is set to 1.
(3) The timing is restarted when the online signal input *online-in* is detected to be at 0 level again; after timing for 500 ms from detecting that the reported online signal input *online-in* is stably kept at 0, the online signal output *online-out* is set to 0 for representing online; the loss signal and the transmission fault signal are subjected to logic processing according to the online signal, and are reported to the switch for setting a real optical signal loss signal output *los-out* and a real transmission fault signal output *txfault-out.*
   In a normal online stage of the transceiver, the online signal output *online-out* is kept at 0; and the real optical signal loss signal output *los-out* and the transmission fault signal output *txfault-out* are reported normally in real time.
(4) After the transceiver is pulled out, if the online signal input *online-in* is detected to be 1, the online signal *online-in* is reported as 1 for representing offline; the optical signal loss signal input *los-in* is 1 for representing invalidity; and the transmission fault signal input *txfault-in* is 1 for representing invalidity.

Apparently, the above are only preferred embodiments of the present invention and are not used for limiting the present invention. Those skilled in the art should understand that the above modules or steps of the present invention can be realized by a universal computing apparatus, and can be concentrated on single computing apparatus or distributed in a network composed of a plurality of computing apparatuses. Alternatively, the modules or steps can be realized by a program code executable to the computing apparatus, and thus can be stored in a storage device and executed by the computing apparatus, or respectively manufactured into integrated circuit modules, or a plurality of modules or steps are manufactured into a single integrated circuit module. In this way, the present invention is not limited to any particular combination of hardware and software.

## Claims

1. A glitch filtering method suitable for an optical signal loss signal, comprising:
setting (S100) an online signal (online-out) to a high level when detecting that the online signal output by a transceiver (online-in) is changed from the high level to a low level, and starting a timer;
setting (S102) the online signal to the high level when detecting that the online signal output by the transceiver is changed from the low level to the high level, and resetting the timer;
determining (22, 322) that the optical signal loss signal of the transceiver (loss-in) is invalid when the online signal (online-out) is set to the high level; and
setting (S104) the online signal to the low level when time of the timer reaches a preset time length.

2. The method according to claim 1, wherein the optical signal loss signal of the transceiver is invalid when the online signal is set to the high level comprises:
the optical signal loss signal of the transceiver and the online signal output by the transceiver are subjected to or-logic processing when the online signal output by the transceiver is at the high level for representing offline and the optical signal loss signal of the transceiver is at the high level for representing invalidity.

3. The method according to claim 1, further comprising:
a transmission fault signal output by the transceiver is invalid when the online signal is set to the high level.

4. The method according to claim 3, wherein the transmission fault signal output by the transceiver is invalid when the online signal is set to the high level comprises:
the transmission fault signal of the transceiver and the online signal output by the transceiver are subjected to or-logic processing (322) when the online signal output by the transceiver is at the high level for representing offline and the transmission fault signal of the transceiver is at the high level for representing invalidity.

5. The method according to any one of claims 1-4, wherein the online signal output by the transceiver is changed from the high level to the low level comprises:
the online signal output by the transceiver is changed from the high level to the low level when the transceiver is plugged in.

6. A glitch filtering apparatus suitable for an optical signal loss signal, comprising:
a filtering module (20, 321), configured to set an online signal (online-out) to a high level when the online signal output by a transceiver (online-in) is detected to be changed from the high level to a low level, and start a timer;
wherein the filtering module (20, 321) is further configured to set the online signal to the high level when the online signal output by the transceiver is detected to be changed from the low level to the high level, and reset the timer; and
the filtering module (20, 321) is further configured to set the online signal to the low level when time of the timer reaches a preset time length; and
a logic module (22, 322), configured to determine that the optical signal loss signal of the transceiver is invalid when the online signal is set to the high level.

7. The apparatus according to claim 6, wherein the logic module (22, 322) is further configured to:
perform or-logic processing on the optical signal loss signal of the transceiver output by the transceiver (loss-in) and the online signal output by the transceiver (online-in) after being processed by the filtering module (20, 231) when the online signal output by the transceiver is at the high level for representing offline and the optical signal loss signal of the transceiver is at the high level for representing invalidity of an optical signal.

8. The apparatus according to claim 6, wherein the logic module (22, 322) is further configured to:
set a transmission fault signal (Txfault-in) output by the transceiver to an invalid high level when the online signal is set to the high level.

9. The apparatus according to claim 8, wherein the transmission fault signal output by the transceiver is invalid when the online signal is set to the high level comprises:
the transmission fault signal of the transceiver and the online signal output by the transceiver are subjected to or-logic processing when the online signal output by the transceiver is at the high level for representing offline and the transmission fault signal of the transceiver is at the high level for representing invalidity.

10. The apparatus according to any one of claims 6-9, wherein the online signal output by the transceiver is changed from the high level to the low level comprises:
the online signal output by the transceiver is changed from the high level to the low level when the transceiver is plugged in.

## Patentansprüche

1. Störungsfilterverfahren, das für ein Signal für optischen Signalverlust geeignet ist, umfassend:
Setzen (S100) eines Online-Signals (online-out) auf ein hohes Niveau, wenn erfasst wird, dass das Online-Signal, das durch einen Sendeempfänger (online-in) ausgegeben wird, von dem hohen Niveau zu einem niedrigen Niveau wechselt, und Starten eines Timers;
Setzen (S102) des Online-Signals auf das hohe Niveau, wenn erfasst wird, dass das Online-Signal, das durch den Sendeempfänger ausgegeben wird, von dem niedrigen Niveau zu dem hohen Niveau wechselt, und Zurücksetzen des Timers;
Bestimmen (22, 322), dass das Signal für optischen Signalverlust des Sendeempfängers (loss-in) ungültig ist, wenn das Online-Signal (online-out) auf das hohe Niveau gesetzt ist; und
Setzen (S104) des Online-Signals auf das niedrige Niveau, wenn Zeit des Timers eine zuvor festgelegte Zeitlänge erreicht.

2. Verfahren nach Anspruch 1, wobei die Ungültigkeit des Signals für optischen Signalverlust des Sendeempfängers, wenn das Online-Signal auf das hohe Niveau gesetzt ist, Folgendes umfasst:
das Signal für optischen Signalverlust des Sendeempfängers und das Online-Signal, das durch den Sendeempfänger ausgegeben wird, werden oder-Logik-Verarbeitung ausgesetzt, wenn das Online-Signal, das durch den Sendeempfänger ausgegeben wird, auf dem hohen Niveau ist, um offline darzustellen, und das Signal für optischen Signalverlust des Sendeempfängers auf dem hohen Niveau ist, um Ungültigkeit darzustellen.

3. Verfahren nach Anspruch 1, ferner umfassend:
ein Übertragungsfehlersignal, das durch den Sendeempfänger ausgegeben wird, ist ungültig, wenn das Online-Signal auf das hohe Niveau gesetzt ist.

4. Verfahren nach Anspruch 3, wobei die Ungültigkeit des Übertragungsfehlersignals, das durch den Sendeempfänger ausgegeben wird, wenn das Online-Signal auf das hohe Niveau gesetzt ist, Folgendes umfasst:
das Übertragungsfehlersignal des Sendeempfängers und das Online-Signal, das durch den Sendeempfänger ausgegeben wird, werden oder-Logik-Verarbeitung (322) ausgesetzt, wenn das Online-Signal, das durch den Sendeempfänger ausgegeben wird, auf dem hohen Niveau ist, um offline darzustellen, und das Übertragungsfehlersignal des Sendeempfängers auf dem hohen Niveau ist, um Ungültigkeit darzustellen.

5. Verfahren nach einem der Ansprüche 1-4, wobei das Wechseln des Online-Signals, das durch den Sendeempfänger ausgegeben wird, von dem hohen Niveau zu dem niedrigen Niveau Folgendes umfasst:
das Online-Signal, das durch den Sendeempfänger ausgegeben wird, wechselt von dem hohen Niveau zu dem niedrigen Niveau, wenn der Sendeempfänger eingesteckt ist.

6. Störungsfiltervorrichtung, die für ein Signal für optischen Signalverlust geeignet ist, umfassend:
ein Filtermodul (20, 321), das konfiguriert ist, um ein Online-Signal (online-out) auf ein hohes Niveau zu setzen, wenn erfasst wird, dass das Online-Signal, das durch einen Sendeempfänger (online-in) ausgegeben wird, von dem hohen Niveau zu einem niedrigen Niveau wechselt, und um einen Timer zu starten;
wobei das Filtermodul (20, 321) ferner konfiguriert ist, um das Online-Signal auf das hohe Niveau zu setzen, wenn erfasst wird, dass das Online-Signal, das durch den Sendeempfänger ausgegeben wird, von dem niedrigen Niveau zu dem hohen Niveau wechselt, und um den Timer zurückzusetzen; und
das Filtermodul (20, 321) ferner konfiguriert ist, um das Online-Signal auf das niedrige Niveau zu setzen, wenn Zeit des Timers eine zuvor festgelegte Zeitlänge erreicht; und
ein Logikmodul (22, 322), das konfiguriert ist, um zu bestimmen, dass das Signal für optischen Signalverlust des Sendeempfängers ungültig ist, wenn das Online-Signal auf das hohe Niveau gesetzt ist.

7. Vorrichtung nach Anspruch 6, wobei das Logikmodul (22, 322) ferner für Folgendes konfiguriert ist:
Durchführen von oder-Logik-Verarbeitung an dem Signal für optischen Signalverlust des Sendeempfängers, das durch den Sendeempfänger (loss-in) ausgegeben wird, und des Online-Signals, das durch den Sendeempfänger (online-in) ausgegeben wird, nach der Verarbeitung durch das Filtermodul (20, 231), wenn das Online-Signal, das durch den Sendeempfänger ausgegeben wird, auf dem hohen Niveau ist, um offline darzustellen, und das Signal für optischen Signalverlust des Sendeempfängers auf dem hohen Niveau ist, um Ungültigkeit eines optischen Signals darzustellen.

8. Vorrichtung nach Anspruch 6, wobei das Logikmodul (22, 322) ferner für Folgendes konfiguriert ist:
Setzen eines Übertragungsfehlersignals (Txfault-in), das durch den Sendeempfänger ausgegeben wird, auf ein ungültiges hohes Niveau, wenn das Online-Signal auf das hohe Niveau gesetzt ist.

9. Vorrichtung nach Anspruch 8, wobei die Ungültigkeit des Übertragungsfehlersignals, das durch den Sendeempfänger ausgegeben wird, wenn das Online-Signal auf das hohe Niveau gesetzt ist, Folgendes umfasst:
das Übertragungsfehlersignal des Sendeempfängers und das Online-Signal, das durch den Sendeempfänger ausgegeben wird, werden oder-Logik-Verarbeitung ausgesetzt, wenn das Online-Signal, das durch den Sendeempfänger ausgegeben wird, auf dem hohen Niveau ist, um offline darzustellen, und das Übertragungsfehlersignal des Sendeempfängers auf dem hohen Niveau ist, um Ungültigkeit darzustellen.

10. Vorrichtung nach einem der Ansprüche 6-9, wobei das Wechseln des Online-Signals, das durch den Sendeempfänger ausgegeben wird, von dem hohen Niveau zu dem niedrigen Niveau Folgendes umfasst:
das Online-Signal, das durch den Sendeempfänger ausgegeben wird, wechselt von dem hohen Niveau zu dem niedrigen Niveau, wenn der Sendeempfänger eingesteckt ist.

## Revendications

1. Procédé de filtrage de problème technique adapté à un signal de perte de signal optique, comprenant :
le réglage (S100) d'un signal en ligne (online-out) à un niveau haut lorsqu'il est détecté que le signal en ligne produit en sortie par un émetteur-récepteur (online-in) est modifié du niveau haut à un niveau bas, et le démarrage d'un temporisateur ;
le réglage (S102) du signal en ligne au niveau haut lorsqu'il est détecté que le signal en ligne produit en sortie par l'émetteur-récepteur est modifié du niveau bas au niveau haut, et la réinitialisation du temporisateur ;
le fait de déterminer (22, 322) que le signal de perte de signal optique de l'émetteur-récepteur (loss-in) est invalide lorsque le signal en ligne (online-out) est réglé au niveau haut ; et
le réglage (S104) du signal en ligne au niveau bas lorsque le temps du temporisateur atteint une durée prédéfinie.

2. Procédé selon la revendication 1, dans lequel le signal de perte de signal optique de l'émetteur-récepteur est invalide lorsque le signal en ligne est réglé au niveau haut, comprenant :
le signal de perte de signal optique de l'émetteur-récepteur et le signal en ligne produit en sortie par l'émetteur-récepteur sont soumis à un traitement logique OU lorsque le signal en ligne produit en sortie par l'émetteur-récepteur est au niveau haut pour représenter le hors ligne et le signal de perte de signal optique de l'émetteur-récepteur est au niveau haut pour représenter l'invalidité

3. Procédé selon la revendication 1, comprenant en outre :
un signal de défaut de transmission produit en sortie par l'émetteur-récepteur est invalide lorsque le signal en ligne est réglé au niveau haut.

4. Procédé selon la revendication 3, dans lequel le signal de défaut de transmission produit en sortie par l'émetteur-récepteur est invalide lorsque le signal en ligne est réglé au niveau haut comprend :
le signal de défaut de transmission de l'émetteur-récepteur et le signal en ligne produit en sortie par l'émetteur-récepteur sont soumis à un traitement logique OU (322) lorsque le signal en ligne produit en sortie par l'émetteur-récepteur est au niveau haut pour représenter le hors ligne et le signal de défaut de transmission de l'émetteur-récepteur est au niveau haut pour représenter l'invalidité.

5. Procédé selon l'une quelconque des revendications 1 à 4, dans lequel le signal en ligne produit en sortie par l'émetteur-récepteur est modifié du niveau haut au niveau bas comprend :
le signal en ligne produit en sortie par l'émetteur-récepteur est modifié du niveau haut au niveau bas lorsque l'émetteur-récepteur est branché.

6. Appareil de filtrage de problème technique adapté à un signal de perte de signal optique, comprenant :
un module de filtrage (20, 321), configuré pour régler un signal en ligne (online-out) à un niveau haut lorsque le signal en ligne produit en sortie par un émetteur-récepteur (online-in) est détecté comme étant modifié du niveau haut à un niveau bas, et démarrer un temporisateur ;
dans lequel le module de filtrage (20, 321) est en outre configuré pour régler le signal en ligne au niveau haut lorsque le signal en ligne produit en sortie par l'émetteur-récepteur est détecté comme étant modifié du niveau bas au niveau haut, et réinitialiser le temporisateur ; et
le module de filtrage (20, 321) est en outre configuré pour régler le signal en ligne sur le niveau bas lorsque le temps du temporisateur atteint une durée prédéfinie ; et
un module logique (22, 322), configuré pour déterminer que le signal de perte de signal optique de l'émetteur-récepteur est invalide lorsque le signal en ligne est réglé au niveau haut.

7. Appareil selon la revendication 6, dans lequel le module logique (22, 322) est en outre configuré pour :
effectuer un traitement logique OU sur le signal de perte de signal optique en ligne de l'émetteur-récepteur produit en sortie par l'émetteur-récepteur (loss-in) et le signal en ligne produit en sortie par l'émetteur-récepteur (online-in) après qu'ils ont été traités par le module de filtrage (20, 231) lorsque le signal en ligne produit en sortie par l'émetteur-récepteur est au niveau haut pour représenter le hors ligne et le signal de perte de signal optique de l'émetteur-récepteur est au niveau haut pour représenter l'invalidité d'un signal optique.

8. Appareil selon la revendication 6, dans lequel le module logique (22, 322) est en outre configuré pour :
régler un signal de défaut de transmission (Txfault-in) produit en sortie par l'émetteur-récepteur à un niveau haut invalide lorsque le signal en ligne est réglé au niveau haut.

9. Appareil selon la revendication 8, dans lequel le signal de défaut de transmission produit en sortie par l'émetteur-récepteur est invalide lorsque le signal en ligne est réglé au niveau haut comprend :
le signal de défaut de transmission de l'émetteur-récepteur et le signal en ligne produit en sortie par l'émetteur-récepteur sont soumis à un traitement logique OU lorsque le signal en ligne produit en sortie par l'émetteur-récepteur est au niveau haut pour représenter le hors ligne et le signal de défaut de transmission de l'émetteur-récepteur est au niveau haut pour représenter l'invalidité.

10. Procédé selon l'une quelconque des revendications 6 à 9, dans lequel le signal en ligne produit en sortie par l'émetteur-récepteur est modifié du niveau haut au niveau bas comprend :
le signal en ligne produit en sortie par l'émetteur-récepteur est modifié du niveau haut au niveau bas lorsque l'émetteur-récepteur est branché.
